# FASCICULE DE BREVET EUROPEEN

(11) **EP 2 356 890 B1**
(45) Date de publication et mention de la délivrance du brevet: **10.08.2016**
(21) Numéro de dépôt: 09768153.0
(22) Date de dépôt: 06.11.2009
(51) Int. Cl.: H05H 1/24, H01J 37/32

(54) **PROCEDE ET SYSTEME POUR AUGMENTER LA DUREE DE VIE D'UN PLASMA**
VERFAHREN UND SYSTEM ZUR VERGRÖSSERUNG DER LEBENSSPANNE EINES PLASMAS
METHOD AND SYSTEM FOR INCREASING THE LIFESPAN OF A PLASMA

(30) Priorité: 07.11.2008 FR 0857608
(43) Date de publication de la demande: 17.08.2011
(73) Titulaire: Ecole Polytechnique, 91120 Palaiseau (FR); Ecole Nationale Supérieure de Techniques Avancées, 75015 Paris (FR); Centre National de la Recherche Scientifique, 75016 Paris (FR)
(72) Inventeur: MYSYROWICZ, André, F-78000 Versailles (FR); FRANCO, Michel, F-75012 Paris (FR)
(74) Mandataire: Nony
(86) Numéro de dépôt international: PCT/FR2009/052141
(87) Numéro de publication internationale: WO 2010/052435

(56) Documents cités:
- FR-A- 2 906 674
- MÉJEAN GUILLAUME ET AL: "Improved laser triggering and guiding of meqavolt discharges with dual fs-ns pulses" APPLIED PHYSICS LETTERS, AIP, AMERICAN INSTITUTE OF PHYSICS, MELVILLE, NY, US, vol. 88, no. 2, 9 janvier 2006 (2006-01-09), pages 21101-021101, XP012081583 ISSN: 0003-6951
- GAUL E W ET AL: "Production and characterization of a fully ionized He plasma channel" APPLIED PHYSICS LETTERS AIP USA, vol. 77, no. 25, 18 décembre 2000 (2000-12-18), pages 4112-4114, XP002531503 ISSN: 0003-6951
- KOSAREVA O G ET AL: "Formation of extended plasma channels in a condensed medium upon axicon focusing of a femtosecond laser pulse" QUANTUM ELECTRONICS TURPION LTD.; KVANTOVAYA ELEKTRONIKA UK, vol. 35, no. 11, novembre 2005 (2005-11), pages 1013-1014, XP002531504 ISSN: 1063-7818
- COUAIRON A ET AL: "Propagation of twin laser pulses in air and concatenation of plasma strings produced by femtosecond infrared filaments" OPTICS COMMUNICATIONS, NORTH-HOLLAND PUBLISHING CO. AMSTERDAM, NL, vol. 225, no. 1-3, 15 septembre 2003 (2003-09-15), pages 177-192, XP004454994 ISSN: 0030-4018

## Description

La présente invention concerne un procédé et un dispositif permettant d'augmenter la durée de vie d'un plasma obtenu lors de la filameritation d'une impulsion femtoseconde.

Le principe de création d'un plasma par filamentation est bien connu. Il s'agit d'ioniser l'atmosphère au moyen d'une impulsion laser intense, créant ainsi une colonne de plasma, autrement appelée filament.

D'une façon générale, le processus de formation d'une région ionisée de l'air supérieure à la distance de Rayleigh du faisceau laser est généralement décrit dans la littérature scientifique sous le vocable de filamentation femtoseconde. Une impulsion laser de haute puissance est capable d'ioniser les molécules de l'atmosphère. La technologie des lasers à impulsions brèves permet d'atteindre des puissances nécessaires pour l'ionisation de l'air avec des énergies par impulsion très modestes, ben inférieure au joule. Ces lasers présentent une durée de l'impulsion inférieure à une picoseconde, soit 10⁻¹² seconde et peuvent atteindre une puissance instantanée supérieure à 10 GW, soit 10⁷ watts.

A titre d'exemple, on a déjà démontré que des impulsions infrarouges de quelques millijoules d'énergie, focalisées dans l'air à l'aide d'une simple lentille, sont suffisantes pour créer un plasma conducteur sur des longueurs de plusieurs centimètres autour du foyer de la lentille. Les impulsions laser provenaient d'un laser femtoseconde ayant comme milieu actif du saphir dopé au titane. Le processus physique entraînant une ionisation de l'air sur une grande longueur est bien identifié, il s'agit d'une compétition entre l'autofocalisation du faisceau laser et l'ionisation multiphotonique impliquant l'absorption simultanée d'un grand nombre de photons infrarouge.

L'inconvénient d'une telle colonne de plasma est que, pour une impulsion donnée, sa durée de vie est très limitée, de l'ordre de quelques nanosecondes. En effet, une fraction seulement des électrons du plasma s'attache aux molécules neutres telles que des molécules d'oxygène, le reste se recombinant rapidement aux ions parents en moins d'une nanoseconde. De plus, la densité électronique d'un tel plasma est généralement assez faible, et sa résistance électrique non nulle, du fait que la majorité des électrons libérés lors du processus de filamentation se recombine en moins d'une nanoseconde aux ions parents.

Selon l'art antérieur voir par example G. Méjean et al. "Improved laser triggering and guiding of megavolt discharges with dual fs-ns pulses", Applied Physics Letters 88, 021101(2006), on connaît des systèmes utilisant une seconde impulsion laser pour capter les électrons encore non recombinés aux ions parents. Ce principe nécessite donc, compte tenu de la rapidité avec laquelle la majorité des électrons libérés se recombine aux ions parents, une extrême synchronisation, quasi instantanée, entre les deux impulsions laser.

La présente invention a pour objet de fournir un procédé et un dispositif permettant, d'augmenter la durée de vie d'un plasma obtenu lors de la filamentation d'une impulsion femtoseconde, sans qu'il ne soit nécessaire de mettre en place une synchronisation extrêmement précise entre les deux impulsions laser mises en oeuvre.

La présente invention a aussi pour objet la création dans l'atmosphère d'un long filament de plasma conducteur.

Un autre but de l'invention est d'obtenir une colonne de plasma dont la densité électronique est accrue par rapport à la densité électronique obtenue lors d'une simple filamentation.

On atteint au moins l'un des objectifs précités avec un procédé pour augmenter la durée de vie d'un plasma obtenu, de préférence dans l'atmosphère ou dans d'autres gaz inertes.

Ce procédé comprend les étapes selon la revendication 1.

Contrairement au système de l'art antérieur, la présente invention s'intéresse aux électrons qui s'attachent aux molécules neutres, et non uniquement aux électrons qui sont libres pendant une très courte période.

La seconde impulsion laser, de durée plus longue que la première impulsion, va permettre d'atteindre une ionisation accrue, voire même totale, du milieu. En effet, l'énergie hv des photons de cette seconde impulsion laser est supérieure à l'énergie d'attachement des électrons aux molécules neutres telles que des molécules d'oxygène, de sorte que lesdits photons permettent le photo-détachement de ces électrons. Les électrons photo-détachés, accélérés par le champ intense du laser, entrent en collision avec d'autres molécules neutres, produisant une nouvelle génération d'électrons, lesquels à leur tour entreront en collision avec d'autres molécules neutres. C'est ce qu'on appelle un phénomène d'avalanche. Ce phénomène d'ionisation par impact et avalanche amène la population électronique à accroître considérablement, jusqu'à ionisation totale du milieu. Le plasma initial se trouve ainsi « enrichi » d'électrons, et forme alors un conducteur électrique offrant une plus faible résistance puisque la population électronique obtenue est supérieure à la population initiale. On obtient ainsi, par phénomène de rupture diélectrique, une colonne de plasma dont la densité électronique égale ou surpasse la densité obtenue lors de la filamentation, et dont la durée de vie est plus longue. Typiquement, la durée de vie de la colonne de plasma obtenue est de trois ordres de grandeur supérieure à la durée de vie de la colonne de plasma initiale.

Dans un mode de réalisation selon l'invention, on utilise un axicon, en particulier une lentille axicon convergeant plano convexe pour focaliser la seconde impulsion laser sur ladite ligne dans la colonne de plasma. Un axicon est en effet une lentille conique, produisant une ligne de focalisation, plutôt qu'un point de focalisation, comme c'est le cas de simples lentilles convergentes par exemple.

Selon un mode de réalisation selon l'invention, la ligne focale de l'axicon coïncide avec l'axe de la colonne de plasma. Ainsi, l'axicon focalisant l'énergie lumineuse de la seconde impulsion laser sur une ligne de focalisation, le phénomène d'ionisation par impact et avalanche a lieu non pas sur un point de la colonne de plasma, mais sur tout un segment de ladite colonne. C'est ce qui permet d'obtenir une colonne de plasma de densité électronique égale ou supérieure à la densité obtenue lors de la filamentation, et de durée de vie plus longue. La longueur de focalisation de la seconde impulsion laser selon l'invention est typiquement de l'ordre du mètre, par exemple comprise entre 50 centimètres et 5 mètres. Dans un mode de réalisation privilégié, on fait focaliser la seconde impulsion laser sur une longueur égale ou sensiblement égale à la longueur du plasma initial.

L'angle du cône de l'axicon selon un mode de réalisation selon l'invention est compris entre 170° et 180°. En effet, plus l'angle du cône est proche de 180°, plus la ligne de focalisation de l'axicon est longue. Il est donc avantageux de recourir à des angles du cône de l'axicon proches de 180°, pour une focalisation sur une longueur importante, de quelques mètres par exemple, mais inférieurs à 180°, de façon à ce que l'axicon reste convergeant. On peut compenser un angle d'axicon moins élevé par une puissance de seconde impulsion laser plus élevée. En effet, un angle d'axicon moins élevé, à puissance fixe, conduit à une ligne de focalisation moins longue. On peut alors compenser cette perte en longueur par une puissance plus élevée de la seconde impulsion traversant l'axicon.

L'instant d'arrivée de la seconde impulsion laser est postérieur à celui de la première impulsion laser. Le délai entre les deux impulsions laser dans le procédé selon l'invention est compris entre quelques microsecondes et quelques millisecondes, typiquement entre 1 microseconde et 10 millisecondes. Ce délai est bien supérieur à la durée de vie du plasma initial qui est de l'ordre de quelques nanosecondes, ce qui s'explique par le fait que les molécules neutres concernées par le processus de filamentation initial gardent une mémoire de cette filamentation. On voit donc que le procédé selon l'invention offre un intervalle de temps assez long durant lequel il est possible d'envoyer la seconde impulsion laser. Il n'est donc pas nécessaire de mettre en oeuvre des processus de synchronisation extrêmement précis. Cependant, le retard possible pour la seconde impulsion peut être raccourci lorsque l'environnement n'est pas favorable, par exemple en présence d'une forte diffusion, de vent, etc. Ce retard dépend également de la longueur de colonne de plasma dont on souhaite augmenter la durée de vie. Plus cette longueur est élevée, plus le retard entre les deux impulsions laser doit être faible.

On utilise pour produire la première impulsion laser, un laser produisant des impulsions de puissance élevée, par exemple comprise entre 0,1 et 100 TW, soit entre 10¹¹ et 10¹⁴ Watts. On parle alors d'une impulsion intense. Il est nécessaire d'avoir une puissance supérieure à la puissance minimum capable de réaliser un filament dans l'air. Celle-ci est de plusieurs GW pour des impulsions à une longueur d'onde de 800 nanomètres. En utilisant des puissances bien supérieures, on crée un faisceau de filaments parallèles, ce qui facilite grandement l'alignement avec l'axe de l'axicon.

On utilise pour produire cette même première impulsion laser, un laser produisant des impulsions ultra courtes, par exemple des impulsions de durée comprise entre 50 et 500 femtosecondes.

Dans un mode de réalisation de l'invention, on utilise, également pour produire cette même première impulsion laser, un laser produisant des impulsions à la longueur d'onde de 800 nanomètres.

On utilise pour produire la seconde impulsion laser, un laser produisant des impulsions de durée plus longue que celle des impulsions ayant servi à former la colonne de plasma. On utilise typiquement un laser produisant des impulsions nanosecondes, par exemple des impulsions de durée comprise entre quelques nanosecondes et quelques dizaines de nanosecondes.

On utilise pour produire cette même seconde impulsion laser, un laser produisant des impulsions d'énergie par exemple égale à plusieurs centaines de milliJoules. On utilise par exemple un laser de type YAG doublé en fréquence, produisant des impulsions à la longueur d'onde de 532 nanomètres. Un avantage lié à l'utilisation d'un tel laser, est qu'il est courant dans le commerce.

Selon un autre aspect de l'invention, il est proposé un dispositif selon la revendication 14.

D'autres particularités et avantages de l'invention apparaîtront à la lecture de la description détaillée d'un exemple de mise en oeuvre nullement limitatif, et des dessins annexés:
- la figure 1 est une vue schématique d'un dispositif permettant de générer la colonne de plasma ;
- la figure 2 est une vue schématique d'un dispositif permuttant d'augmenter la durée de vie de ladite colonne de plasma selon l'invention ; et
- la figure 3 est une vue schématique d'un dispositif global permettant de générer la colonne de plasma puis d'augmenter sa durée de vie selon la présente invention.

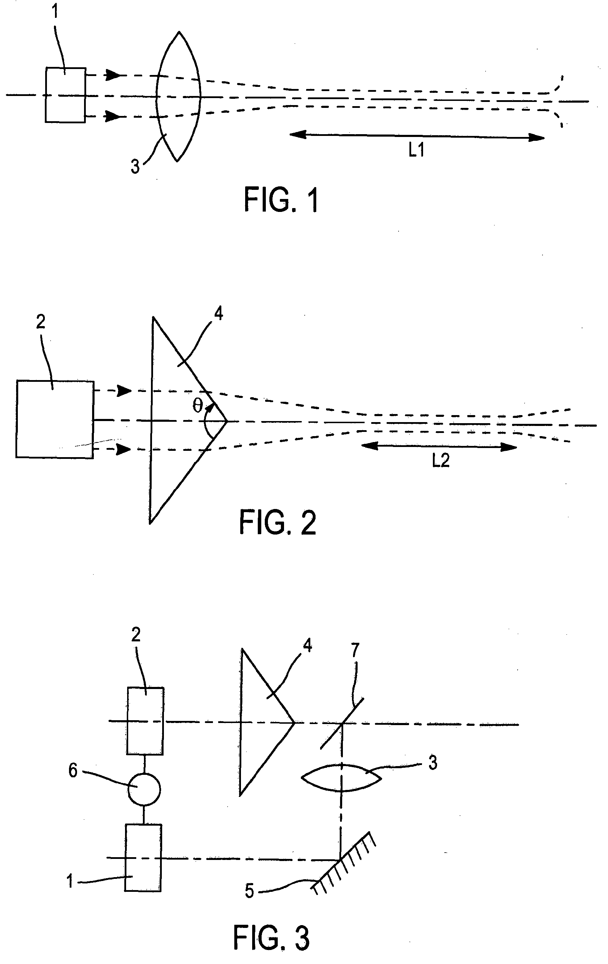

L'invention va être à présent décrite en référence aux figures 1 à 3.

Le dispositif selon l'invention, pour augmenter la durée de vie d'un plasma dans l'air, comprend les caractéristiques de la revendication 14.

Dans un mode de réalisation privilégié, le laser à impulsion 1 est focalisé par une lentille convergente 3 de focale par exemple égale à 2 mètres. On utilise avantageusement un laser produisant des impulsions de quelques milliJoules, par exemple 15 milliJoules, de durée 50 femtosecondes, à la longueur d'onde 800 nanomètres. On utilise par exemple un laser Titane : Saphir.

Selon un mode de réalisation privilégié, la colonne de plasma obtenue grâce à la première impulsion laser a une longueur L1 de 1 mètre. Elle a une densité d'électrons de l'ordre de 10¹⁷ électrons par centimètres cube. La majorité de ces électrons se recombine avec les molécules ionisées, et environ 10¹⁴ électrons par centimètres cube se piègent sur des molécules neutres telles que des molécules d'oxygène. Ces derniers électrons sont faiblement liés aux molécules neutres, et on peut les en détacher facilement à l'aide d'un second laser. On parle à ce stade de filamentation.

La durée de vie de la colonne de plasma est courte, de l'ordre de quelques nanosecondes.

Dans ce même mode de réalisation privilégié, le second laser 2 est un laser Néodyme YAG, d'énergie 250 milliJoules par impulsion, à la longueur d'onde 532 nanomètres. On peut parler pour le second laser 2 de « laser d'enrichissement ». La durée d'une impulsion est supérieure à celle de l'impulsion ayant permis de former la colonne de plasma, aussi appelée filament, soit quelques nanosecondes à plusieurs dizaines de nanosecondes. Dans un exemple de réalisation, on utilise une durée d'impulsion pour le second laser 2 de l'ordre de dix nanosecondes. L'énergie par impulsion du second laser 2 est dans ce mode de réalisation de l'ordre du Joule, plus précisément de 250 milliJoules. Plus l'énergie par impulsion du second laser est élevée, mieux le procédé fonctionne. La fréquence du second laser 2, liée à sa longueur d'onde, peut être dans le visible, le proche infrarouge, ou l'infrarouge plus lointain, pourvu que l'énergie d'un photon d'une impulsion soit supérieure à l'énergie d'attachement des électrons aux molécules neutre telles que les molécules d'oxygène, soit 0,15 eV. L'impulsion du second laser 2 va ainsi permettre le photo-détachement des électrons desdites molécules neutres. Ainsi, les électrons, initialement libérés, puis captés par des molécules neutres, sont à nouveau libérés, mais aussi suffisamment accélérés par le champ électrique intense du second laser 2 pour qu'ils produisent de nouvelles générations d'électrons libres par un processus d'avalanche. On dit que le plasma initial est revitalisé.

Le second laser 2 est focalisé par un axicon 4, en particulier une lentille axicon convergeant plano convexe. L'axicon 4 permet de faire focaliser l'impulsion laser due au second laser 2 sur une longueur importante, que l'on fait coïncider avec la colonne de plasma en réglant la position du second laser 2.

La figure 3 montre un mode de réalisation dans lequel on utilise un miroir 5 à 45° placé sur le trajet optique de la première impulsion issue du laser à impulsion 1. Ce miroir 5 renvoie la première impulsion vers un miroir dichroïque 7 via la lentille convergente 3. Ce miroir dichroïque 7 a pour fonction de superposer la première impulsion avec la seconde impulsion provenant du second laser 2 via l'axicon 4. Selon ce mode de réalisation, le trajet optique de la seconde impulsion reste linéaire alors que le trajet optique de la première impulsion laser subit deux réflexions à 45°. En d'autres termes, le miroir dichroïque 7 est réfléchissant pour la seconde impulsion, et est transparent pour la première impulsion, de sorte que l'on peut superposer les trajets optiques suivis par les deux impulsions à la sortie de ce miroir dichroïque 7. Dans un mode de réalisation privilégié, l'angle du cône θ de l'axicon est égal à 179°. Un des avantages liés à l'utilisation d'un axicon, est que l'on peut libérer des électrons des molécules neutres, sur une longueur L2 de l'ordre de quelques mètres, supérieure à la distance de Rayleigh. Dans un mode de réalisation privilégié, on a L1 égale à L2, c'est-à-dire que la longueur sur laquelle on focalise l'impulsion émise par le second laser 2 est égale à la longueur du plasma initialement créé. Dans le cas où on utiliserait un angle de cône pour l'axicon inférieur à 179°, il faudrait augmenter la puissance du second laser 2 de façon à augmenter l'énergie par impulsion, et ainsi conserver une même longueur L2.

La revitalisation de la colonne de plasma permet d'obtenir une colonne de plasma dont la densité électronique peut égaler ou même surpasser la densité obtenue initialement, lors de la filamentation. En outre, ladite colonne de plasma revitalisée a une durée de vie beaucoup plus longue que la colonne de plasma initiale.

L'instant d'arrivée de la seconde impulsion laser est postérieur à la première impulsion, le délai entre ces impulsions pouvant être réglé entre quelques microsecondes et quelques millisecondes. Sur la figure 3, on utilise un générateur de délai 6 permettant de contrôler le délai entre ces deux impulsions. Ce délai est supérieur à la durée de vie du plasma initialement créé, laquelle durée de vie est de l'ordre de quelques nanosecondes, ce qui est rendu possible par le fait que les molécules d'oxygène concernées par le processus de filamentation conservent une mémoire de cette filamentation. Dans un mode de réalisation privilégié, on obtient une augmentation substantielle de la densité électronique le long de l'axe du filament pour un décalage de l'ordre d'une milliseconde entre les deux impulsions laser. Ce décalage temporel, ou retard, acceptable pour que la revitalisation du plasma ait lieu, peut diminuer lorsque les conditions ne sont pas favorables, par exemple en présence de vent, ou de phénomènes de diffusion accrue. Un tel retard acceptable lorsque l'on utilise un axicon est à comparer au retard acceptable lorsque l'on utilise une lentille classique. Dans ce cas, le délai entre les deux impulsions laser peut être typiquement compris entre 10 et 50 microsecondes.

On peut ainsi revitaliser sur plusieurs mètres un plasma initial d'une longueur allant jusqu'à une centaine de mètres, d'un rayon de l'ordre de 10 micromètres, et d'une durée de vie de l'ordre de quelques nanosecondes. La revitalisation permet d'obtenir une colonne de plasma dont la durée de vie est de trois ordres de grandeurs de plus que la durée de vie du plasma initial, on peut atteindre des durées de vie de l'ordre de 100 microsecondes par exemple.

Il existe de nombreuses applications à un tel dispositif et au procédé associé. D'une façon générale, cela permet de déposer des décharges électriques à distances, à un endroit particulier voulu.

A titre d'exemple non limitatif, le procédé et le dispositif selon la présente invention permettent de déclencher la foudre, en formant dans l'air un long filament de plasma conducteur. Le principe général de guidage de la foudre par procédé optique consiste à multiplier les électrons jusqu'à provoquer une décharge, ou rupture diélectrique permettant la formation d'un plasma de longue durée. Pour déclencher la foudre par un tel procédé optique, il est nécessaire de former dans l'air un long filament de plasma conducteur. Cette possibilité existe par filamentation, au cours de laquelle une impulsion ultracourte (par exemple 50 à 500 femtosecondes), de puissance élevée (par exemple 0,1 à 100 TW, soit 10¹¹ à 10¹⁴ Watts) s'autofocalise par l'effet Kerr optique jusqu'à ce que l'intensité sur l'axe soit devenue suffisante pour ioniser l'air par effet de multiphotoionisation, c'est-à-dire éjection par un photon d'un ou plusieurs électrons d'un atome, un ion ou une molécule. L'effet Kerr optique est produit par le champ électrique du rayon lumineux, et consiste en une variation linéaire de l'indice de réfraction du milieu de propagation avec l'intensité lumineuse du rayon se propageant. L'avantage de ce procédé optique est qu'une fois formée, l'ionisation défocalise le faisceau, ce qui conduit par le biais d'une compétition entre autofocalisation et défocalisation à une longue colonne de plasma, de plusieurs centaines de mètres de longueur. Cependant, l'inconvénient de ce procédé optique selon l'art antérieur est le fait que la durée de vie du plasma créé est courte, de l'ordre de quelques nanosecondes, et que seulement une fraction des molécules de l'air est ionisée, conduisant à créer un filament de plasma dont la résistance électrique n'est pas nulle. Comme on l'a vu précédemment, la raison de cette courte durée de vie est qu'une fraction des électrons du plasma s'attache aux molécules neutres telles que des molécules d'oxygène, le reste se recombinant rapidement aux ions parents en moins d'une nanoseconde.

La présente invention est notamment remarquable par le fait qu'elle ouvre une ère nouvelle de développement de systèmes optiques de déclenchement de la foudre. Pour ce faire, on commence par chercher, par temps d'orage, une région dans le ciel favorable au déclenchement de la foudre. On crée ensuite une colonne de plasma à l'endroit voulu, que l'on enrichi par le procédé selon la présente invention, le champ électrique de l'orage favorisant la libération d'électrons.

Cette colonne de plasma fortement conductrice d'électricité permet alors de guider la foudre en frayant un chemin à un éclair.

De façon schématique, on décharge un nuage fortement chargé en électrons en établissant, grâce à la colonne de plasma fortement conductrice d'électricité, la connexion électrique avec le sol, lequel est électriquement neutre. Une telle colonne de plasma, à forte densité électronique accrue et à résistance diminuée, permet également de décharger un câble chargé, par exemple pour des questions de sécurité. En effet, un plasma peut conduire énormément de courant.

Bien sûr, l'invention n'est pas limitée aux exemples qui viennent d'être décrits et de nombreux aménagements peuvent être apportés à ces exemples sans sortir du cadre de l'invention.

La portée de l'invention est définie par les revendications.

## Revendications

1. Procédé pour augmenter la durée de vie d'un plasma, ce procédé comprenant les étapes suivantes :
- émission d'une impulsion laser femtoseconde dite première impulsion, générant par phénomène de filamentation une colonne de plasma, et
- émission d'une seconde impulsion laser que l'on focalise sur une ligne dans la colonne de plasma, l'énergie des photons de cette seconde impulsion laser étant supérieure à l'énergie d'attachement des électrons du plasma à des molécules neutres telles que des molécules d'oxygène, **caractérisé en ce que** Je délai entré les deux impulsions laser est compris entre 1 microseconde et 10 millisecondes.

2. Procédé selon la revendication 1, **caractérisé en ce qu'**on utilise un axicon pour focaliser la seconde impulsion laser sur ladite ligne.

3. Procédé selon la revendication 2, **caractérisé en ce que** la ligne focale de l'axicon coïncide avec l'axe de la colonne de plasma.

4. Procédé selon la revendication 2 ou 3, **caractérisé en ce que** l'angle du cône de l'axicon est compris entre 170° et 180°.

5. Procédé selon l'une quelconque des revendications précédentes, **caractérisé en ce que** la durée de la seconde impulsion est supérieure à la durée de la première impulsion.

6. Procédé selon l'une quelconque des revendications précédentes, **caractérisé en ce qu'**on utilise pour produire la première impulsion laser, un laser produisant des impulsions de puissance comprise entre 0,1 et 100 TW, soit entre 10¹¹ et 10¹⁴ Watts.

7. Procédé selon l'une quelconque des revendications précédentes, **caractérisé en ce qu'**on utilise pour produire la première impulsion laser, un laser produisant des impulsions de durée comprise entre 50 et 500 femtosecondes.

8. Procédé selon l'une quelconque des revendications précédentes, **caractérisé en ce qu'**on utilise pour produire la première impulsion laser, un laser produisant des impulsions à la longueur d'onde de 800 nanomètres.

9. Procédé selon l'une quelconque des revendications précédentes, **caractérisé en ce qu'**on utilise pour produire la seconde impulsion laser, un laser produisant des impulsions nanosecondes.

10. Procédé selon l'une quelconque des revendications précédentes, **caractérisé en ce qu'**on utilise pour produire la seconde impulsion laser, un laser produisant des impulsions d'énergie égale à plusieurs centaines de milliJoules.

11. Procédé selon l'une quelconque des revendications précédentes, **caractérisé, en ce qu'**on utilise pour produire la seconde impulsion laser, un laser YAG.

12. Procédé selon l'une quelconque des revendications précédentes, **caractérisé en ce que** la longueur de focalisation de la seconde impulsion laser est comprise entre 50 centimètres et 5 mètres.

13. Procédé selon l'une quelconque des revendications précédentes, **caractérisé en ce que** la longueur de focalisation de la seconde impulsion laser est identique à la longueur de la colonne de plasma.

14. Dispositif pour augmenter la durée de vie d'un plasma obtenu dans l'atmosphère ou dans d'autres gaz, ce dispositif comprenant :
- un premier laser à impulsions produisant une impulsion laser femtoseconde dite première impulsion, laquelle génère par phénomène de filamentation une colonne de plasma, et
- un second laser produisant une seconde impulsion laser que l'on focalise sur une ligne dans la colonne de plasma, l'énergie des photons de cette seconde impulsion laser étant supérieure à l'énergie d'attachement des électrons du plasma à des molécules neutres telles que des molécules d'oxygène,
**caractérisé par** un générateur de délai configuré pour instaurer un délai entre les deux impulsions laser compris entre 1 microseconde et 10 millisecondes.

## Patentansprüche

1. Verfahren zur Vergrößerung der Lebensspanne eines Plasmas, wobei dieses Verfahren die folgenden Schritte umfasst:
- Senden eines Femtosekunden-Laserimpulses, erster Impuls genannt, der durch ein Filamentationsphänomen eine Plasmasäule erzeugt, und
- Senden eines zweiten Laserimpulses, der auf eine Linie in der Plasmasäule fokussiert wird, wobei die Energie der Photonen dieses zweiten Laserimpulses größer als die Bindungsenergie der Elektronen des Plasmas an neutralen Molekülen, wie Sauerstoffmolekülen, ist, **dadurch gekennzeichnet, dass** die Frist zwischen den beiden Laserimpulsen zwischen 1 Mikrosekunde und 10 Millisekunden beträgt.

2. Verfahren nach Anspruch 1, **dadurch gekennzeichnet, dass** ein Axikon zum Fokussieren des zweiten Laserimpulses auf der Linie verwendet wird.

3. Verfahren nach Anspruch 2, **dadurch gekennzeichnet, dass** die Fokallinie des Axikons mit der Achse der Plasmasäule zusammenfällt.

4. Verfahren nach Anspruch 2 oder 3, **dadurch gekennzeichnet, dass** der Winkel des Kegels des Axikons zwischen 170° und 180° beträgt.

5. Verfahren nach einem der vorhergehenden Ansprüche, **dadurch gekennzeichnet, dass** die Dauer des zweiten Impulses größer als die Dauer des ersten Impulses ist.

6. Verfahren nach einem der vorhergehenden Ansprüche, **dadurch gekennzeichnet, dass** zur Erzeugung des ersten Laserimpulses ein Laser verwendet wird, der Leistungsimpulse zwischen 0,1 und 100 TW, d.h. zwischen 10¹¹ und 10¹⁴ Watt, erzeugt.

7. Verfahren nach einem der vorhergehenden Ansprüche, **dadurch gekennzeichnet, dass** zur Erzeugung des ersten Laserimpulses ein Laser verwendet wird, der Impulse mit einer Dauer zwischen 50 und 500 Femtosekunden erzeugt.

8. Verfahren nach einem der vorhergehenden Ansprüche, **dadurch gekennzeichnet, dass** zur Erzeugung des ersten Laserimpulses ein Laser verwendet wird, der Impulse mit der Wellenlänge von 800 Nanometern erzeugt.

9. Verfahren nach einem der vorhergehenden Ansprüche, **dadurch gekennzeichnet, dass** zur Erzeugung des zweiten Laserimpulses ein Laser verwendet wird, der Nanosekunden-Impulse erzeugt.

10. Verfahren nach einem der vorhergehenden Ansprüche, **dadurch gekennzeichnet, dass** zur Erzeugung des zweiten Laserimpulses ein Laser verwendet wird, der Impulse mit einer Energie gleich mehreren Hundert Millijoule erzeugt.

11. Verfahren nach einem der vorhergehenden Ansprüche, **dadurch gekennzeichnet, dass** zur Erzeugung des zweiten Laserimpulses ein YAG-Laser verwendet wird.

12. Verfahren nach einem der vorhergehenden Ansprüche, **dadurch gekennzeichnet, dass** die Fokussierungslänge des zweiten Laserimpulses zwischen 50 Zentimeter und 5 Meter beträgt.

13. Verfahren nach einem der vorhergehenden Ansprüche, **dadurch gekennzeichnet, dass** die Fokussierungslänge des zweiten Laserimpulses mit der Länge der Plasmasäule identisch ist.

14. Vorrichtung zur Vergrößerung der Lebensspanne eines Plasmas, das in der Atmosphäre oder anderen Gasen gewonnen wird, wobei diese Vorrichtung umfasst:
- einen ersten Impulslaser, der einen Femtosekunden-Laserimpuls, erster Impuls genannt, erzeugt, der durch ein Filamentationsphänomen eine Plasmasäule erzeugt, und
- einen zweiten Laser, der einen zweiten Laserimpuls erzeugt, der auf eine Linie in der Plasmasäule fokussiert wird, wobei die Energie der Photonen dieses zweiten Laserimpulses größer als die Bindungsenergie der Elektronen des Plasmas an neutralen Molekülen, wie Sauerstoffmolekülen, ist, **gekennzeichnet durch** einen Verzögerungsgenerator, der ausgeführt ist, um eine Frist zwischen den beiden Laserimpulsen zwischen 1 Mikrosekunde und 10 Millisekunden einzurichten.

## Claims

1. Method for increasing the lifetime of a plasma, this method comprising the following steps:
- emitting a femtosecond laser pulse called the first pulse that generates by a filamentation effect a plasma column; and
- emitting a second laser pulse that is focused on a line in the plasma column, the energy of the photons of this second laser pulse being higher than the energy of attachment of the electrons of the plasma to neutral molecules such as oxygen molecules, **characterized in that** the delay between the two laser pulses is comprised between 1 microsecond and 10 milliseconds.

2. Method according to Claim 1, **characterized in that** an axicon is used to focus the second laser pulse on said line.

3. Method according to Claim 2, **characterized in that** the focal line of the axicon coincides with the axis of the plasma column.

4. Method according to Claim 2 or 3, **characterized in that** the angle of the cone of the axicon is comprised between 170° and 180°.

5. Method according to any one of the preceding claims, **characterized in that** the duration of the second pulse is larger than the duration of the first pulse.

6. Method according to any one of the preceding claims, **characterized in that** a laser producing pulses of power comprised between 0.1 and 100 TW, i.e. between 10¹¹ and 10¹⁴ watts, is used to produce the first laser pulse.

7. Method according to any one of the preceding claims, **characterized in that** a laser producing pulses of duration comprised between 50 and 500 femtoseconds is used to produce the first laser pulse.

8. Method according to any one of the preceding claims, **characterized in that** a laser producing pulses at the wavelength of 800 nanometres is used to produce the first laser pulse.

9. Method according to any one of the preceding claims, **characterized in that** a laser producing nanosecond pulses is used to produce the second laser pulse.

10. Method according to any one of the preceding claims, **characterized in that** a laser producing pulses of energy equal to several hundred millijoules is used to produce the second laser pulse.

11. Method according to any one of the preceding claims, **characterized in that** a YAG laser is used to produce the second laser pulse.

12. Method according to any one of the preceding claims, **characterized in that** length of focus of the second laser pulse is comprised between 50 centimetres and 5 metres.

13. Method according to any one of the preceding claims, **characterized in that** the length of focus of the second laser pulse is identical to the length of the plasma column.

14. Device for increasing the lifetime of a plasma obtained in the atmosphere or in other gases, this device comprising:
- a first pulsed laser producing a femtosecond laser pulse called the first pulse, which generates by a filamentation effect a plasma column; and
- a second laser producing a second laser pulse that is focused on a line in the plasma column, the energy of the photons of this second laser pulse being higher than the energy of attachment of the electrons of the plasma to neutral molecules such as oxygen molecules, **characterized by** a delay generator configured to generate a delay between the two laser pulses comprised between 1 microsecond and 10 milliseconds.
